Europäisches Patentamt

European Patent Office

Office européen des brevets

(19)

(11) Publication number: **0 224 843 B1**

(12) **EUROPEAN PATENT SPECIFICATION**

(45) Date of publication of patent specification: **25.09.91**    (51) Int. Cl.5: **G03F 7/26**

(21) Application number: **86116317.8**

(22) Date of filing: **25.11.86**

(54) Method for developing negative photoresists.

(30) Priority: **25.11.85 US 801635**

(43) Date of publication of application:
**10.06.87 Bulletin 87/24**

(45) Publication of the grant of the patent:
**25.09.91 Bulletin 91/39**

(84) Designated Contracting States:
**DE FR GB IT**

(56) References cited:
**US-A- 3 458 313**
**US-A- 3 703 373**

**IBM TECHNICAL DISCLOSURE BULLETIN, vol. 18, no. 3, August 1975, page 715, New York, US; G.T. CHIU et al.: "Azeotropic mixtures for resist development"**

**JOURNAL FÜR SIGNALAUFZEICHNUNGS-MATERIALIEN, vol. 8, no. 6, November/December 1980, pages 405-432, Akademie Verlag, Berlin, DD; H. BÖTTCHER: "Photopolymere Systeme zur Informations-speicherung: Ergebnisse und Probleme"**

**PATENT ABSTRACTS OF JAPAN, vol. 8, no. 38 (P-255)[1475], 18th February 1984; & JP-**

**A-58 192 036 (NIPPON DENKI K.K.) 09-11-1983**

(73) Proprietor: **International Business Machines Corporation**
**Old Orchard Road**
**Armonk, N.Y. 10504(US)**

(72) Inventor: **Anschel, Morris**
**4612 Salem Drive**
**Binghamton, N.Y. 13903(US)**
Inventor: **Goodrich, Lawrence Duane**
**P.O.B. 254**
**Endicott N.Y. 13760(US)**
Inventor: **Hetrick, Barton Maitland**
**534A William Reuben Drive**
**Endicott, N.Y. 13760(US)**

(74) Representative: **Mönig, Anton, Dipl.-Ing.**
**IBM Deutschland GmbH Patentwesen und Urheberrecht Schönaicher Strasse 220**
**W-7030 Böblingen(DE)**

## Description

This invention relates generally to a method for developing exposed images in negative photoresists.

The use of photoresists in the fabrication of integrated circuits is well-known. Typically, the surface of a substrate is cleaned, and the desired photoresist composition is applied, generally by spinning, so as to form a uniform coating of the photoresist on the substrate. The coated substrate is dried to drive off solvents and selected portions in some desired pattern are exposed to electromagnetic radiation, usually in the visible region. During exposure, incident radiation effects a chemical change in the resist film which creates a differential solubility in selected solvents (called "developers") between exposed and unexposed resists. In the case of negative resists, exposed areas become insolubilized in virtually all solvents.

Following exposure, the coated substrate is developed by treatment with a solvent. The common methods for developing exposed images in negative resists, such as polyisoprene-type resists, involve dipping or spraying the coated surface with ambient temperature solvents, such as xylene, Stoddard solvents or trichloroethane. In "Journal für Signalaufzeichnungsmaterialien", Vol. 8, No. 6, (1980), 405 - 432 and US-A-3 703 373, trichloroethylene is disclosed as a solvent for photoresists. Spray techniques have also been employed. However, implicit in these methods are tank-spray evaporative losses and solvent loss from drying. Spray processes, while offering superior removal of unexposed resist, contribute to the loss of exposed resist and image lifting due to mechanical action. Another alternative process, the hot (boiling) solvent process, employs perchloroethane or trichloroethane. This process offers low emissions resulting from the use of vapor degreasing equipment, which has been designed to reduce emissions. However, the hot solvent process has not been found acceptable for fine image work, since the boiling solvent temperatures can cause the resist to reflow, thereby degrading the image.

IBM Technical Disclosure Bulletin, Volume 18, No.3, August 1975, page 715 describes the use of azeotropic mixtures for resist development.

It is the object of the invention to provide a developing method for exposed negative photoresists where the solvent-loss is minimized and image degrading due to resist reflow is avoided and an application of said method.

This object is achieved by a method as defined in claim 1 and by an application as defined in claim 7.

Employing the process of the invention permits development of negative resists comparable to that achieved by present spray processes. Further, the process of the invention can be applied to present conveyorized in-line vapor degreasing equipment, whereby emissions are minimized.

Advantageous embodiments of the inventive method are indicated in the subclaims.

The invention will become more apparent from the following detailed description.

The process of the invention for developing exposed negative photoresists on substrates comprises treating the photoresist with a mixture comprising trichloroethane and a short chain aliphatic alcohol. The alcohol is present in an amount equal to or less than the azeotropic (constant boiling) composition.

The trichloroethane is preferably 1,1,1-trichloroethane (methyl chloroform), and preferably includes stabilizing agents, as is well-known in the use of this compound. Such stabilizers, of which one or more may be present, inhibit metal-induced decomposition or hydrolysis of the 1,1,1-trichloroethane resulting from its use in the degreasing equipment. Any of the conventional stabilizers may be employed, such as dioxane, nitromethane, butylene oxide, amines and methyl isopropyl ketone. Other suitable stabilizers are disclosed in U.S. Patent 4 018 837. Such stabilizers, however, do not form a part of this invention.

The alcohol employed is a short chain aliphatic compound, preferably having from 1 to 4 carbon atoms. Examples include methanol, isopropanol and tert-butanol. Of these, isopropanol and tert-butanol are preferred, with isopropanol being most preferred.

The alcohol is present in an amount equal to or less than the azeotropic composition. In the case of tricholorethane/isopropanol, the azeotropic composition is about 17 weight % isopropanol.

In the processing of semiconductor wafers or printed circuit (PC) boards (plastic or ceramic) to fabricate devices and circuits thereon, there are several stages at which a layer, e.g., an oxide or metal, must be patterned. This is generally accomplished by applying a coating of a photoresist, exposing the photoresist to electromagnetic radiation, such as the visible region, and, in the case of negative photoresists, removing the regions unexposed to the radiation by means of a solvent called a developer. Removal of such selected portions of the photoresist exposes portions of the underlying layer (oxide or metal), which may be removed by treating the so-exposed portions with an agent that removes the exposed portions of the layer without attacking the remaining photoresist.

For example, in the patterning of a layer, such as a metal layer to form ohmic contacts, a coating of a negative photoresist is applied. An example of such a negative photoresist is a polyisoprene. Other negative photoresists, of course, may also be employed in the practice of the invention. Suitable commercial negative photoresists include KODAK KTFR (Kodak Co., Rochester, N.Y.) and WAYCOAT SC Resists (Hunt Chemical Co., Palisades Park, N.J.).

The surface of the semiconductor wafer of PC board is cleaned as necessary. The coating of negative photoresist is then applied, typically by spinning the photoresist in a suitable solvent to achieve a substantially uniform thickness. The photoresist is dried and/or baked as necessary and is then exposed, employing a mask to delineate regions where non-exposure is desired. Conventionally, a light source (visible region of the electromagnetic spectrum) is employed.

Following exposure, the photoresist is developed in a solvent. In accordance with the invention, the solvent employed is the trichloroethane/alcohol mixture described above.

Subsequent to developing, the remaining photoresist may be treated with one or more solvents to deswell the photoresist as desired. A post-bake may also be done in accordance with conventional processing. The regions of oxide or metal uncovered by the developing process are then etched away, leaving a desired pattern of oxide or metal, covered by the remaining photoresist. The remaining photoresist may be left in place or removed, as desired.

It will be understood that the steps prior to and subsequent to the developing process are conventional in the prior art and hence do not form a part of this invention.

In the process of the invention, the exposed negative photoresist is treated with the trichloroethane/alcohol mixture, optionally heated to an elevated temperature, preferably at or near boiling. In particular, the coated substrate may variously be immersed in the vapors resulting from the heating of the composition dipped in or sprayed with the hot composition. For example, the process of vapor immersion - 30 sec./dip. - 60 sec./vapor rinse - 30 sec. has been found to result in development comparable to that obtained from present spray methods. The preferred heating process of the invention is more chemically active than a cool solvent process, although the cool process performs substantially in the same manner, but the immersion time is longer.

As mentioned earlier, boiling trichloroethane without the presence of alcohol causes the resist to reflow. The reflow of the resist causes wetting of chrome and copper surfaces, for example, which results in degradation of the image. However, boiling trichloroethane does provide excellent resistance to etchants (etch undercutting), but can only be used on surfaces covered by a resist of uniform thickness (uniform reflow). With the alcohol present, the etchant resistance is better than that of a cool trichloroethane process, but less than that of pure boiling trichloroethane. On the other hand, the presence of the alcohol results in an image superior to that obtained by using pure trichloroethane.

The isopropanol/trichloroethane mixture employed in the process of the invention performs better than pure trichloroethane at ambient and elevated temperatures. The difference in use (hot vs. cool) is the time required to solubilize the unexposed resist. The hot process has the real economic advantage of using presently-employed vapor degreasing equipment for minimum chemical emulsions.

Without subscribing to any particular theory, it appears that the underlying advantage of the process of the invention hinges upon the swelling of the resist. Isoprene resists are developed by hydrocarbon solvents which cause the polymer to swell. Unexposed regions with little to no cross-linking swell to the point of removal (hence the spray advantage). In swelling, the film loses some of its initial adhesion to the surface. This is partially corrected with post-baking.

Alcohol is known to shrink isoprene polymers. If used pure, it shrinks the polymer so much that more adhesion is lost.

By adding alcohol to the initial developing "hydrocarbon" solution, the swelling action is hindered as to keep the film-metal adhesion intact. Since unexposed resist is not cross-linked, it is still solubilized.

EXAMPLES

Example 1

An alumina ceramic substrate was coated with three metal layers: a chrome layer about 80 nanometers (nm) thick, a copper layer about 8 000 nm thick, and a chrome layer about 80 nm thick. A thin coating of KODAK KTFR (about 3 000 nm) was sprayed and dried over the top chrome layer. A portion of the photoresist was exposed to 70 millijoules of 360 nm UV light. The unexposed portions of the photoresist were completely removed by treating with a heated mixture of 17 wt % isopropanol, balance trichloroethane, employing the following schedule:
vapor immersion 30 sec.
dip 60 sec.
vapor rinse 30 sec.

The resulting resist images were optically examined at 400X. High resolution images were observed for lines as small as 0.01 millimeter (mm). Following a resist post-bake (120° C, 5 min.), the metal regions not covered by resist were removed by etching the top chrome layer in potassium permanganate, the copper layer in ferric chloride and the bottom chrome layer in potassium permanganate. The remaining photoresist was removed by treatment in a phenol strip solution. An optical measurement of the resultant metal lines showed a 0.1 mm resist line to have produced a 0.08 mm line, with 0.01 mm undercut.

Example 2

An alumina ceramic substrate was coated as in Example 1 with three metal layers of chrome, copper and chrome, followed by the thin coating of Kodak photoresist. The thicknesses of the respective layers was as in Example 1. A portion of the photoresist was exposed to 70 millijoules of 360 nm UV light. The unexposed portions of the photoresist were completely removed by treating with a 25° C mixture of 17 wt % isopropanol, balance trichloroethane, employing the following schedule:
dip in stirred vessel 60 sec.

The resulting resist images were examined as in Example 1, with high resolution images observed for lines as small as 0.01 mm. Following a resist post-bake under the condition of Example 1, the metal regions not covered by resist were removed employing the etchants listed in Example 1. An optical measurement of the resultant metal lines showed a 0.1 mm resist line to have produced a 0.08 mm metal line, with 0.01 mm undercut.

Example 3

An alumina ceramic substrate was processed as in Example 1, except that tert-butanol was employed in place of the isopropanol. The same schedule for treating the unexposed portions of photoresist was employed. The results obtained were identical to those observed with the substrate in Example 1.

Example 4

An alumina ceramic substrate was processed as in Example 3, except that the tert-butanol was maintained at 25° C. The schedule and the remaining processing was the same as in Example 2. The results obtained were identical to those observed in Example 3.

Example 5

An alumina ceramic substrate was processed as in Example 1, except that the photoresist employed was Hunt WAYCOAT SC negative photoresist. The schedule and the remaining processing was the same as in Example 1. The results obtained were identical to those observed in Example 1.

It is to be understood that the above described embodiment of the invention is illustrative only, and that modifications thereof may occur to those skilled in the art. Accordingly, this invention is not be regarded as limited to the embodiments as disclosed herein, but is to be limited only as defined by the appended claims.

**Claims**

1. Process for developing exposed images in negative photoresists comprising treating a substrate coated with the photoresist with a mixture of trichloroethane and a short chain aliphatic alcohol, said alcohol present in an amount up to that forming a constant boiling mixture, i.e. an azeotropic composition, whereby

said mixture is heated to boiling and the substrate is treated with the vapors generated thereby.

2. Process according to claim 1 in which said mixture contains additionally a stabilizing agent for trichloroethane.

3. Process according to claim 1 in which said trichloroethane consists of 1,1,1-trichloroethane.

4. Process according to claim 1 or 2 in which said short chain alcohol consists of 1 to 4 carbon atoms.

5. Process according to claim 3 in which said short chain alcohol consists of an alcohol selected from the group consisting of methanol, ispropanol and tertbutanol.

6. Process according to claim 4 in which isopropanol is present in said mixture in an amount of about 17 weight %.

7. Application of the process according to any one of claims 1 to 6 in the fabrication of devices and circuits in or on semiconductor substrates including the steps of:

   a) forming a coating of negative photoresist composition on a surface of said substrate;
   b) exposing portions of said negative photoresist to electromagnetic radiation; and
   c) developing the exposed negative photoresist in solvent, according to claims 1-6.

**Revendications**

1. Procédé pour le développement d'images exposées dans des photoréserves négatives, caractérisé en ce qu'il comprend le traitement d'un substrat revêtu de la photoréserve avec un mélange de trichloroéthane et d'un alcool aliphatique à chaîne courte, cet alcool étant présent en une quantité allant jusqu'à celle qui forme un mélange à point d'ébullition constant, c'est-à-dire une composition azéotropique, selon lequel ce mélange est chauffé à ébullition et le substrat est traité avec les vapeurs ainsi générées.

2. Procédé suivant la revendication 1, caractérisé en ce que ce mélange contient de plus un agent stabilisant pour le trichloroéthane.

3. Procédé suivant la revendication 1, caractérisé en ce que ce trichloroéthane consiste en 1,1,1-trichloroéthane.

4. Procédé suivant la revendication 1 ou la revendication 2, caractérisé en ce que cet alcool à chaîne courte a 1 à 4 atomes de carbone.

5. Procédé suivant la revendication 3, caractérisé en ce que cet alcool à chaîne courte est un alcool choisi dans le groupe comprenant le méthanol, l'isopropanol et le t-butanol.

6. Procédé suivant la revendication 4, caractérisé en ce que l'isopropanol est présent dans ce mélange en une quantité d'environ 17% en poids.

7. Application du procédé suivant l'une quelconque des revendications 1 à 6 dans la fabrication de dispositifs et de circuits dans ou sur des substrats semiconducteurs, caractérisée en ce qu'elle comprend les étapes de :
    a) formation d'un revêtement d'une composition de photoréserve négative sur une surface de ce substrat;
    b) exposition de parties de cette photoréserve négative à une radiation électromagnétique; et
    c) développement de la photoréserve négative exposée dans un solvant suivant l'une quelconque des revendications 1 à 6.

**Patentansprüche**

1. Verfahren zum Entwickeln belichteter Abbildungen in Negativ-Photolacken umfassend die Behandlung eines mit dem Photolack bedeckten Substrats mit einer Mischung aus Trichlorethan und einem kurzkettigen aliphatischen Alkohol, wobei dieser Alkohol zu einem Anteil vorliegt, so daß ein Gemisch mit konstantem Siedepunkt entsteht, d.h. ein azeotropes Gemisch,

wobei dieses Gemisch bis zum Sieden erhitzt wird und das Substrat mit den dabei entstehenden Dämpfen behandelt wird.

2. Verfahren nach Anspruch 1, wobei das Gemisch zusätzlich einen Stabilisator für Trichlorethan enthält.

3. Verfahren nach Anspruch 1, wobei das Trichlorethan ein 1,1,1-Trichlorethan ist.

4. Verfahren nach Anspruch 1 oder 2, wobei der kurzkettige Alkohol 1 bis 4 Kohlenstoffatome enthält.

5. Verfahren nach Anspruch 3, wobei der kurzkettige Alkohol aus Methanol, Isopropanol oder Tertbutanol besteht.

6. Verfahren nach Anspruch 4, wobei Isopropanol in dem Gemisch mit einem Gewichtsanteil von etwa 17% vorliegt.

7. Anwendung des Verfahren nach einem der Ansprüche 1 bis 6 in der Produktion von Bauelementen oder Schaltkreisen in oder auf Halbleitersubstraten einschließlich der Schritte:

    a) Bildung einer Bedeckung einer Substratoberfläche mit einer Negativ-Photolack Zusammensetzung,
    b) Belichten von Teilen dieses Negativ-Photolacks mit elektromagnetischer Strahlung und
    c) Entwicklung des belichteten Negativ-Photolacks in einer Lösung entsprechend den Ansprüchen 1 bis 6.